# DEMANDE DE BREVET EUROPEEN

(11) **EP 1 249 760 A1**
(43) Date de publication de la demande: **16.10.2002**
(21) Numéro de dépôt: 02076396.7
(22) Date de dépôt: 08.04.2002
(51) Int. Cl.: G06F 13/16, G06F 13/40, H04N 5/00

(54) **Dispositif de traitement de données par plusieurs processeurs**

(30) Priorité: 12.04.2001 FR 0105022
(71) Demandeur: Koninklijke Philips Electronics N.V., 5621 BA Eindhoven (NL)
(72) Inventeur: Duranton, Marc, 75008 Paris (FR)
(74) Mandataire: de la Fouchardière, Marie-Noelle

(57) **Abrégé**

Un dispositif de traitement de données comprend plusieurs processeurs, par exemple 101, devant accéder à un système mémoire 150. Le système mémoire 150 comprend au moins deux mémoires 111 et 112. Le dispositif de traitement de données comprend un bus, par exemple 121, par mémoire. Les bus sont reliés entre eux par au moins un pont, par exemple 131. Un processeur est relié à un bus et le dispositif de traitement de données comprend au moins une table de mémoires, par exemple 141, spécifiant avec quelle mémoire un échange d'une donnée entre un processeur et le système mémoire 150 doit être effectué. L'invention permet une diminution des temps de latence dans le traitement des données et une augmentation de la bande passante. Elle présente notamment un intérêt dans des systèmes où la contrainte temps réel est importante, par exemple des systèmes de traitement de données vidéo.

## Description

### DOMAINE TECHNIQUE

L'invention concerne un dispositif de traitement de données comprenant plusieurs processeurs devant accéder à un système mémoire.
L'invention trouve son application, par exemple, dans un système dédié à une application avec des contraintes de type temps réel, tel un dispositif de traitement de données vidéo. Par exemple, un processeur de rendu d'images peut constituer un tel dispositif de traitement de données vidéo. Ce processeur de rendu d'images peut être inclus, par exemple, dans un décodeur, un dispositif récepteur décodeur pour télévision (en anglais «Set Top Box»), ou une télévision.

### ETAT DE LA TECHNIQUE ANTERIEURE

Dans des circuits intégrés, des traitements de données peuvent être effectués par plusieurs processeurs qui ont accès à des données stockées dans une mémoire. La demande internationale de brevet WO95/32578 décrit un décodeur pour télévision numérique comprenant plusieurs processeurs et une mémoire externe. Des transferts de données entre la mémoire externe et les différents processeurs se font grâce à un bus collectif. Une unité de contrôle gère la mémoire externe et le bus collectif pour assurer au mieux les transferts de données.

Des transferts de données entre un processeur et une mémoire se font en général via un bus, comme il est décrit dans la demande internationale de brevet citée ci-dessus. Un schéma classique consiste à utiliser un bus collectif à travers lequel différents processeurs peuvent accéder a une mémoire collective. Lorsque plusieurs processeurs sont reliés à une seule mémoire par un bus collectif, les processeurs ne peuvent accéder simultanément à cette mémoire, ce qui engendre des temps de latence relativement importants dans le traitement des données, car un processeur désirant accéder à la mémoire doit attendre que celle-ci se libère. Or, pour des applications avec des contraintes de type temps réel, tel un traitement de données vidéo, il est nécessaire de réduire ces temps de latence. En outre, pour assurer ces transferts de données, le bus doit avoir une certaine bande passante en terme de nombre de bits par unité de temps. Une somme des vitesses auxquelles les processeurs consomment et produisent des données, en cas de lectures ou d'écritures de données dans la mémoire, détermine la bande passante nécessaire pour le bus. Or, avec l'évolution de technologies comme un standard haute définition en télévision numérique, les bandes passantes de bus requises sont grandes et peuvent difficilement être atteintes avec un schéma tel que celui décrit ci-dessus.

### EXPOSE DE L'INVENTION

Un but de l'invention est de proposer un dispositif de traitement de données permettant d'augmenter la bande passante et de diminuer les temps de latence introduits ci-dessus.

Selon l'invention, un dispositif de traitement de données tel que défini dans le paragraphe d'ouverture est caractérisé en ce que :
- le système mémoire comprend au moins deux mémoires ;
- le dispositif de traitement de données comprend un bus par mémoire ;
- les bus sont reliés entre eux par au moins un pont ;
- un processeur est relié à un bus et
- le dispositif de traitement de données comprend au moins une table de mémoires spécifiant avec quelle mémoire un échange d'une donnée entre un processeur et le système mémoire doit être effectué.

Lorsqu'un processeur désire effectuer un échange de données avec le système mémoire, c'est à dire lorsqu'il désire lire ou écrire des données dans le système mémoire, il spécifie au bus auquel il est relié une adresse du système mémoire à laquelle il désire lire ou écrire ces données. Ce bus définit alors, grâce à une table de mémoires, dans quelle mémoire les données considérées doivent être lues ou écrites et à quel emplacement dans la mémoire les données doivent être lues ou écrites. Si cette mémoire est directement reliée à ce bus, l'échange des données a lieu à travers le bus. Si cette mémoire est reliée à un autre bus, l'échange des données a lieu à travers le ou les ponts reliant cet autre bus et le bus auquel le processeur considéré est relié. Ainsi deux processeurs pourront accéder simultanément au système mémoire si les données auxquelles ils désirent avoir accès se trouvent dans des mémoires différentes. Il en résulte une augmentation de la bande passante, du fait d'un nombre plus élevé de bus, et une réduction des temps de latence.

Dans un mode de réalisation particulier de l'invention, le dispositif de traitement de données comprend un arbitre destiné à définir un ordre de priorité d'accès à une mémoire donnée par les processeurs dans un cas où plusieurs processeurs désirent accéder simultanément à cette mémoire donnée. Cet arbitre permet de réduire les temps de latence en cas de conflit, c'est-à-dire lorsque plusieurs processeurs désirent accéder simultanément à une même mémoire. En outre, il est possible de réduire bon nombre de conflits en effectuant un placement judicieux des données dans les mémoires.

### BREVE DESCRIPTION DES FIGURES

L'invention sera mieux comprise et d'autres détails apparaîtront dans la description qui va suivre en regard des dessins annexés qui sont donnés à titre d'exemples non limitatifs et dans lesquels :
- la figure 1 est un schéma illustrant des caractéristiques de l'invention ;
- la figure 2 illustre un exemple d'architecture de dispositif de traitement de données comprenant une seule mémoire ;
- la figure 3 illustre un exemple d'architecture de dispositif de traitement de données utilisant deux processeurs et des coprocesseurs selon l'invention ;
- la figure 4 illustre un exemple d'application de l'invention dans un circuit de traitement de données audiovisuelles.

### EXPOSE DETAILLE D'AU MOINS UN MODE DE REALISATION DE L'INVENTION

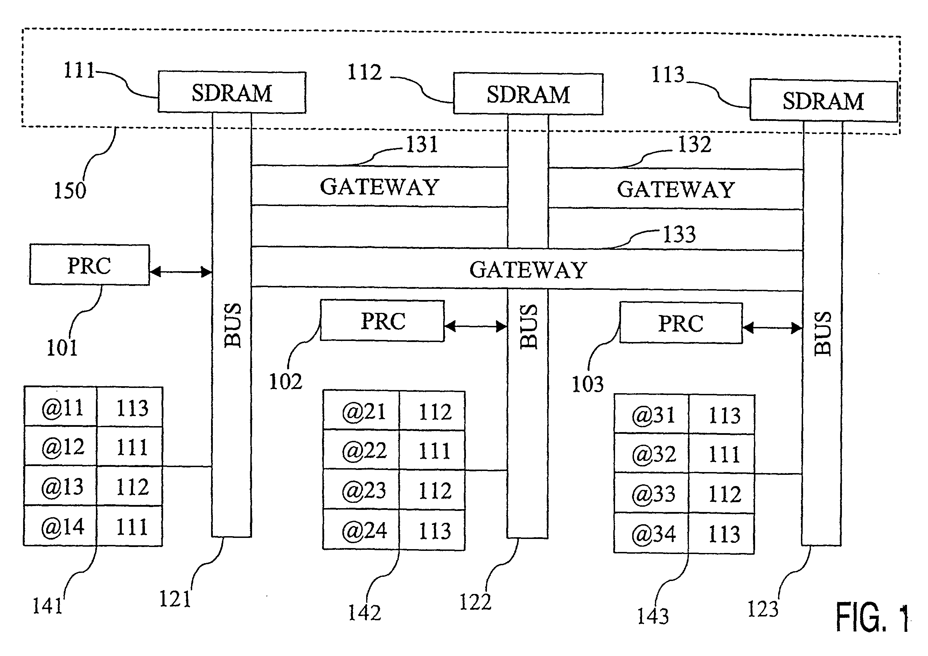

La figure 1 illustre des caractéristiques de l'invention. Un dispositif de traitement de données selon l'invention comprend un premier processeur 101, un deuxième processeur 102, un troisième processeur 103, une première mémoire 111, une deuxième mémoire 112, une troisième mémoire 113, un premier bus 121, un deuxième bus 122, un troisième bus 123, un premier pont 131, un deuxième pont 132, un troisième pont 133, une première table de mémoires 141, une deuxième table de mémoires 142 et une troisième table de mémoires 143. L'ensemble des trois mémoires 111, 112 et 113 forme un premier système mémoire 150. L'exemple illustré ici s'applique à trois processeurs devant accéder à trois mémoires synchrones dynamiques. Il est évident que l'invention s'applique à des quantités différentes de processeurs ou de mémoires synchrones dynamiques. Par ailleurs, l'invention s'applique également à d'autres types de mémoires, par exemple des mémoires dynamiques ou des mémoires statiques.

Lorsque le premier processeur 101 désire lire ou écrire une donnée dans le premier système mémoire 150, il spécifie une adresse de cette donnée au premier bus 121. Grâce à la première table de mémoires 141 contenue dans le premier bus 121, celui-ci définit dans quelle mémoire 111, 112 ou 113 la donnée doit être lue ou écrite. Dans un cas où la donnée doit être lue dans la première mémoire 111, un transfert de cette donnée s'effectue à travers le premier bus 121. Dans un cas où la donnée doit être lue dans la deuxième mémoire 112, un transfert de cette donnée s'effectue à travers le premier pont 131 et le premier bus 121. Dans un cas où la donnée doit être lue dans la troisième mémoire 113, un transfert de cette donnée s'effectue à travers le troisième pont 133 et le premier bus 121. Du point de vue du premier processeur 101, le fait que la donnée à lire se trouve dans la première mémoire 111, la deuxième mémoire 112 ou la troisième mémoire 113 n'a pas d'importance ; la lecture d'une donnée s'effectue de la même façon que s'il n'existait qu'une seule mémoire, qui serait le premier système mémoire 150. De ce fait, un modèle d'architecture de mémoire unifiée est respecté, ce qui est bénéfique pour un programmateur chargé de programmer le dispositif de traitement de données. Un raisonnement identique s'applique pour l'écriture d'une donnée dans le premier système mémoire 150, ainsi que pour un accès au premier système mémoire 150 par le deuxième processeur 102 et le troisième processeur 103. Si, comme dans l'art antérieur, il n'y avait qu'une seule mémoire, il y aurait un conflit dès lors qu'au moins deux processeurs désireraient lire ou écrire des données simultanément dans cette seule mémoire . Ici, il est possible qu'au moins deux processeurs puissent lire ou écrire des données simultanément dans le premier système mémoire 150, dès lors que les mémoires dans lesquelles ces données doivent être lues ou écrites sont différentes. Par exemple, supposons que le premier processeur 101 désire lire une donnée qui se trouve dans la deuxième mémoire 112, que le deuxième processeur 102 désire lire une donnée qui se trouve dans la première mémoire 111 et que le troisième processeur 103 désire lire une donnée qui se trouve dans la troisième mémoire 113, ces actions seront possibles simultanément, ce qui n'aurait pas été possible dans l'art antérieur. Par conséquent, le fait d'utiliser plusieurs bus et plusieurs mémoires permet d'augmenter la bande passante et de diminuer les temps de latence. Le fonctionnement des tables de mémoires 141, 142 et 143 est le suivant. La première table de mémoires 141 est liée au premier bus 121, la deuxième table de mémoires 142 est liée au deuxième bus 122 et la troisième table de mémoires 143 est liée au troisième bus 123. La partie gauche de chacune des tables de mémoires comprend des adresses dans le premier système mémoire 150. La partie droite de chacune des tables de mémoires indique à quelle mémoire 111, 112 ou 113 ces adresses correspondent. Par exemple, l'adresse @11 sera spécifiée par le premier processeur 101 lorsqu'il désirera lire la donnée stockée à cette adresse dans le premier système mémoire 150. La première table de mémoires 141 permettra alors au premier bus 121 de définir la mémoire dans laquelle cette donnée doit être lue, c'est à dire dans le cas présent la première mémoire 111. De la même façon la donnée stockée à l'adresse @23 dans le premier système mémoire 150 se situe dans la deuxième mémoire 112 et la donnée stockée à l'adresse @33 dans le premier système mémoire 150 se situe dans la deuxième mémoire 112. Il est à noter que les adresses dans les parties gauches des tables de mémoire peuvent être identiques pour deux tables de mémoire différentes, deux tables de mémoire différentes pouvant désirer accéder à des données identiques.

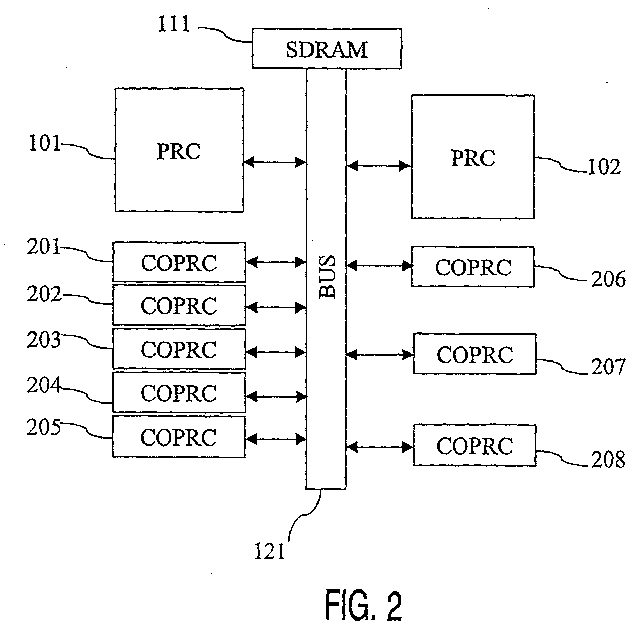

La figure 2 illustre un exemple d'architecture de dispositif de traitement de données comprenant une seule mémoire. Un tel dispositif de traitement de données comprend le premier processeur 101, le deuxième processeur 102, la première mémoire 111, le premier bus 121 et huit coprocesseurs numérotés de 201 à 208. Les coprocesseurs 201 à 205 sont les coprocesseurs du premier processeur 101 et les coprocesseurs 206 à 208 sont les coprocesseurs du deuxième processeur 102. Il est évident que le nombre de coprocesseurs est choisi ici à titre d'exemple et qu'il peut être plus ou moins élevé.

Si au moins deux des coprocesseurs 201 à 205 ou au moins un des coprocesseurs 201 à 205 et le premier processeur 101 désirent simultanément lire ou écrire une donnée dans la première mémoire 111, un arbitre, non représenté sur la figure 2, est chargé de définir, parmi les coprocesseurs 201 à 205 et le premier processeur 101, lequel est prioritaire pour avoir accès à la première mémoire 111. Il en est de même pour le deuxième processeur 102 et les coprocesseurs 206 à 208. Un tel arbitre est connu de l'homme du métier ; il peut mettre en oeuvre par exemple un schéma d'accès fixe ou un schéma d'accès par priorité connus de l'homme du métier. Supposons que le premier processeur 101 et le deuxième processeur 102 soient prioritaires pour accéder à la première mémoire 111, et que ces deux processeurs désirent simultanément lire ou écrire une donnée dans la première mémoire 111. L'arbitre doit alors définir lequel de ces processeurs est prioritaire pour accéder à la première mémoire 111, et seul un des deux processeurs aura alors accès à la première mémoire 111. Il en résulte des temps de latence relativement longs.

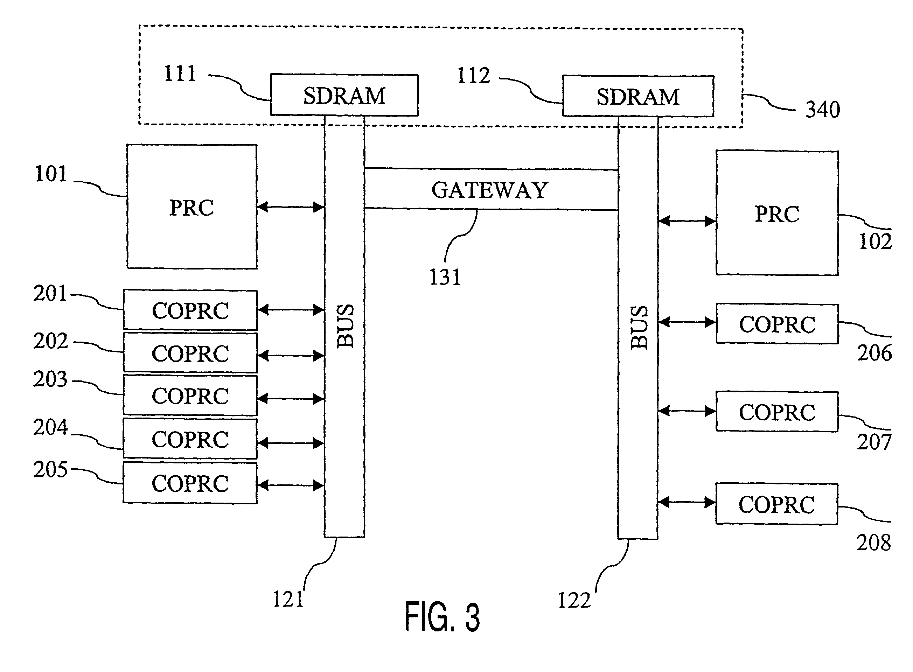

La figure 3 illustre un exemple d'architecture de dispositif de traitement de données utilisant deux processeurs et des coprocesseurs selon l'invention. Un tel dispositif de traitement de données comprend le premier processeur 101, le deuxième processeur 102, la première mémoire 111, la deuxième mémoire 112, le premier bus 121, le deuxième bus 122, le premier pont 131 et les huit coprocesseurs 201 à 208. L'ensemble des deux mémoires 111 et 112 forme un deuxième système mémoire 340. La première table de mémoires 141 ainsi que la deuxième table de mémoires 142, décrites sur la figure 1, n'ont pas été représentées sur la figure 3.

Une définition d'un ordre de priorité, pour un accès au deuxième système mémoire 340, entre le premier processeur 101 et les coprocesseurs 201 à 205 est effectuée comme il a été précisé dans la description de la figure 2. Il en est de même entre le deuxième processeur 102 et les coprocesseurs 206 à 208. Supposons que le coprocesseur 204 et le deuxième processeur 102 soient chacun prioritaires pour lire une donnée dans le deuxième système mémoire 340. Si les tables de mémoires du premier bus 121 et du deuxième bus 122, dont le fonctionnement a été précisé dans la description de la figure 1, indiquent que la donnée devant être lue par le coprocesseur 204 se trouve dans la première mémoire 111 et que la donnée devant être lue par le deuxième processeur 102 se trouve dans la deuxième mémoire 112, les données pourront être lues simultanément à travers le premier bus 121 et le deuxième bus 122. Si les tables de mémoires du premier bus 121 et du deuxième bus 122 indiquent que la donnée devant être lue par le coprocesseur 204 se trouve dans la deuxième mémoire 112 et que la donnée devant être lue par le deuxième processeur 102 se trouve dans la première mémoire 111, les données pourront être lues simultanément à travers le premier bus 121, le deuxième bus 122 et le premier pont 131. Cependant, si les tables de mémoires du premier bus 121 et du deuxième bus 122 indiquent que les données devant être lues par le coprocesseur 204 et le deuxième processeur 102 se trouvent dans la même mémoire 111 ou 112, il y aura conflit et un arbitre sera alors chargé de définir un ordre de priorité entre le coprocesseur 204 et le deuxième processeur 102. Il sera alors avantageux d'utiliser le même arbitre que celui introduit dans la description de la figure 2. A la lumière de ce qui vient d'être décrit, on s'aperçoit que le nombre de conflits se trouve considérablement réduit par rapport à l'art antérieur. Par ailleurs, il est possible de placer judicieusement les données dans les différentes mémoires. En effet, les données auxquelles le deuxième processeur 102 ainsi que les coprocesseurs 206 à 208 n'auront pas ou peu accès seront avantageusement placées dans la première mémoire 111 et les données auxquelles le premier processeur 101 ainsi que les coprocesseurs 201 à 205 n'auront pas ou peu accès seront avantageusement placées dans la deuxième mémoire 112. Un tel placement judicieux pourra avoir lieu lors d'une compilation d'un programme définissant différentes opérations à effectuer par le dispositif de traitement de données. De la sorte, le nombre de conflits se trouve encore réduit. Par conséquent, l'invention permet, par rapport à l'art antérieur, d'obtenir une bande passante multipliée par un facteur proche de deux et des temps de latence divisés par un facteur également proche de deux, ceci dans l'exemple d'architecture considérée ici qui comporte deux mémoires 111 et 112.

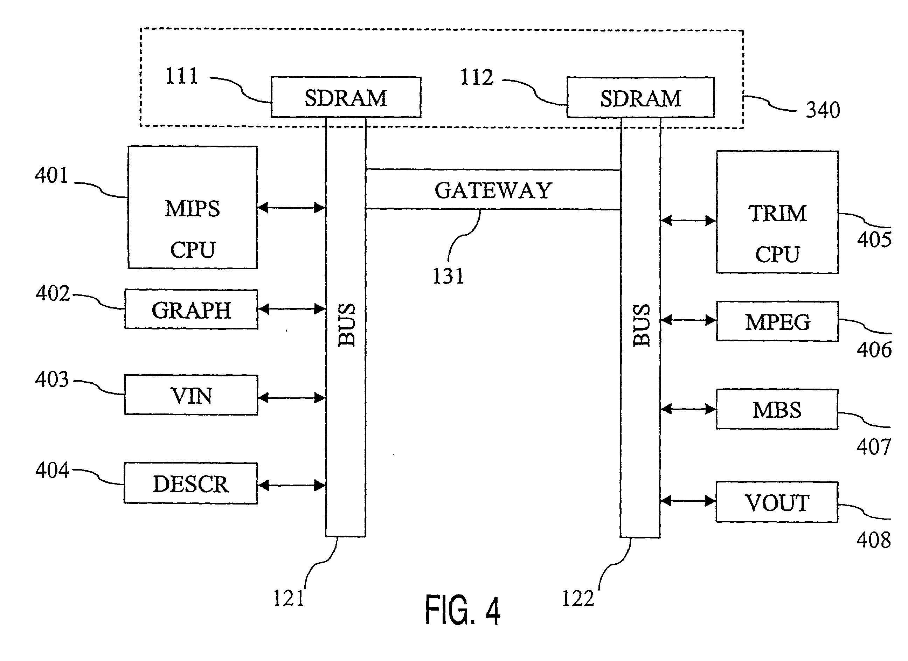

La figure 4 illustre un exemple d'application de l'invention dans un processeur de rendu d'images pour le traitement de données audiovisuelles. Un tel processeur de rendu d'images comprend, outre des éléments déjà décrits dans les figures précédentes, un processeur de contrôle 401, un coprocesseur de graphique 402, un coprocesseur d'entrée 403, un coprocesseur de décryptage 404, un processeur de traitement 405, un coprocesseur de décodage 406, un coprocesseur de formats 407 et un coprocesseur de sortie 408.

Le processeur de contrôle 401 est notamment responsable d'applications interactives, de fonctions de contrôle et de traitements graphiques. Le processeur de traitement 405 est notamment responsable du traitement des données audiovisuelles en temps réel. Un processeur peut effectuer divers traitements de données, ou demander à un de ses coprocesseurs d'effectuer certains traitements. Le coprocesseur d'entrée 403 est chargé de stocker un flux de données audiovisuelles cryptées dans le deuxième système mémoire 340. Le coprocesseur de décryptage 404 est chargé de décrypter ces données, et de placer les données décryptées dans le deuxième système mémoire 340. Le coprocesseur de graphique 402 peut ajouter des données graphiques aux données audiovisuelles, les données résultant d'un tel traitement étant stockées dans le deuxième système mémoire 340. Le coprocesseur de décodage 406 est chargé de décoder les données audiovisuelles, par exemple des données à un format MPEG. Le coprocesseur de formats 407 se charge de convertir des données d'un format à un autre. Par exemple, il peut convertir des données audiovisuelles d'un format haute définition vers un format de définition standard. Le coprocesseur de sortie 408 se charge d'envoyer les données audiovisuelles ainsi traitées vers un autre dispositif de traitement, par exemple un écran de télévision. Par conséquent, les processeurs et les coprocesseurs ont tous besoin d'avoir accès au deuxième système mémoire 340. Or, les données audiovisuelles peuvent comprendre plusieurs trames successives. C'est le cas d'une succession d'images formant un film. Dans ce cas, chaque image doit être successivement traitée par le circuit de traitement . Si l'on suppose que 25 images doivent ainsi être traitées en une seconde, on comprend que le nombre de conflits entre les différents processeurs et coprocesseurs est assez élevé, et de ce fait que le temps de traitement des données audiovisuelles est assez élevé. L'invention, en permettant de réduire ce nombre de conflits, permet de diminuer le temps de traitement.

Un tel processeur de rendu d'images peut être incorporé, par exemple, dans un décodeur, un dispositif récepteur décodeur pour télévision, une télévision, une unité centrale d'ordinateur ou un écran d'ordinateur. Un tel processeur de rendu d'images peut être utilisé dans un système de communication comprenant au moins un émetteur apte à envoyer des signaux représentant au moins une image, un réseau de transmission, et un récepteur apte à recevoir lesdits signaux.

La description ci-dessus en référence aux figures illustre l'invention plutôt qu'elle ne la limite. A cet égard, quelques remarques sont faites ci-dessous. Les figures 1, 3 et 4 illustrent des exemples d'architecture de dispositifs de traitement de données selon l'invention. Il est possible de mettre en oeuvre l'invention de manière différente, sans s'éloigner de l'esprit de l'invention. Par exemple, on peut envisager des mises en oeuvre de l'invention avec des quantités plus grandes ou plus faibles de processeurs, de coprocesseurs, de mémoires, de ponts et de tables de mémoires. Par ailleurs, l'invention peut être appliquée à un grand nombre de systèmes électroniques, et pas seulement à un dispositif de traitement de données audiovisuelles. A ce titre, l'invention sera avantageusement utilisé dans un système électronique requerrant de larges bandes passantes et des temps de latence relativement faibles.

## Revendications

1. Dispositif de traitement de données comprenant plusieurs processeurs devant accéder à un système mémoire, **caractérisé en ce que** :
- le système mémoire comprend au moins deux mémoires ;
- le dispositif de traitement de données comprend un bus par mémoire ;
- les bus sont reliés entre eux par au moins un pont ;
- un processeur est relié à un bus et
- le dispositif de traitement de données comprend au moins une table de mémoires spécifiant avec quelle mémoire un échange d'une donnée entre un processeur et le système mémoire doit être effectué.

2. Dispositif de traitement de données selon la revendication 1, **caractérisé en ce qu'**il comprend un arbitre destiné à définir un ordre de priorité d'accès à une mémoire parmi les au moins deux mémoires dans un cas où plusieurs processeurs désirent accéder simultanément à ladite mémoire.

3. Processeur de rendu d'images comprenant un dispositif de traitement de données selon l'une des revendications 1 ou 2.

4. Dispositif récepteur décodeur pour télévision comprenant au moins un processeur de rendu d'images selon la revendication 3.

5. Dispositif comprenant au moins un écran destiné à afficher des images et un processeur de rendu d'images selon la revendication 3.

6. Système de communication comprenant au moins un émetteur apte à envoyer des signaux représentant au moins une image, un réseau de transmission, un récepteur apte à recevoir les dits signaux et un processeur de rendu d'images selon la revendication 3.
